# EUROPEAN PATENT SPECIFICATION

(11) **EP 0 696 078 B1**
(45) Date of publication and mention of the grant of the patent: **12.01.2000**
(21) Application number: 95305296.6
(22) Date of filing: 28.07.1995
(51) Int. Cl.: H01P 7/10

(54) **Microwave oscillator and its manufacturing method**
Mikrowellenoszillator und Verfahren zu dessen Herstellung
Oscillateur hyperfréquence et procédé pour sa fabrication

(30) Priority: 02.08.1994 JP 18124894
(43) Date of publication of application: 07.02.1996
(73) Proprietor: MATSUSHITA ELECTRIC INDUSTRIAL CO., LTD., Kadoma-shi, Osaka-fu, 571 (JP)
(72) Inventor: Morino, Takayoshi, Takatsuki-shi, Osaka 569 (JP); Kashima, Yukiro, Takatsuki-shi, Osaka 569 (JP)
(74) Representative: Crawford, Andrew Birkby

(56) References cited:
- DE-A- 2 941 826
- FR-A- 2 438 937
- US-A- 4 484 162
- US-A- 4 588 964
- PATENT ABSTRACTS OF JAPAN vol. 18 no. 10 (E-1487) ,10 January 1994 & JP-A-05 251913 (MURATA MFG CO LTD) 28 September 1993,
- PATENT ABSTRACTS OF JAPAN vol. 12 no. 469 (E-691) ,8 December 1988 & JP-A-63 190405 (FUJITSU LTD) 8 August 1988,
- PATENT ABSTRACTS OF JAPAN vol. 18 no. 105 (E-1512) ,21 February 1994 & JP-A-05 304386 (NEC CORP) 16 November 1993,
- ELECTRONIC COMPONENTS AND APPLICATIONS, vol. 5, no. 2, February 1983 EINDHOVEN NL, pages 85-99, W. GOEDBLOED ET AL. 'Microwave integrated circuits-design and realisation'

## Description

### FIELD OF THE INVENTION

The present invention relates to a composition and method of manufacturing a microwave oscillator used in high frequency communication apparatus, broadcasting apparatus and the like.

### CONVENTIONAL ART

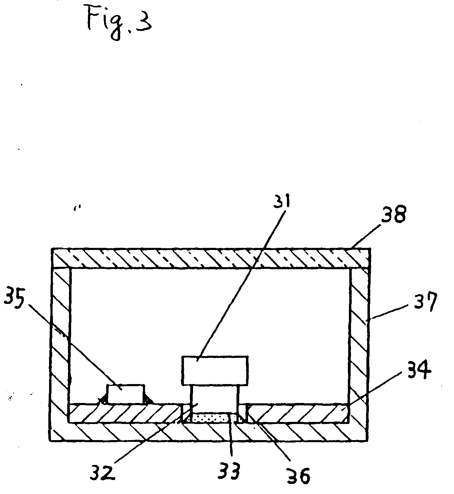

Figure 3 shows a conventional microwave oscillator. A substrate 34 having a circuit pattern (not shown) and a soldered electronic component 35 thereon is fixed in the bottom of a case 37 using, for example, screws not shown. After then, the base 32 of a dielectric resonator 31 is fixed to the bottom of the case 37 using an adhesive 33 such as epoxy resin through a perforated hole 36 of the substrate setting a position of the dielectric resonator 31. Further, a shield plate 38 made of metal plate such as aluminum closes the top of the case 37 and is fixed using, for example, screws not shown.

### SUMMARY OF THE INVENTION

DE-A-2941826 discloses a microwave oscillator comprising a substrate having a conductor on the top surface, a grounding conductor covering the bottom surface, and a hole, an FET mounted on the top surface of the substrate, a metal plate fixed to the bottom surface of the substrate closing the bottom of the hole, and a dielectric resonator fixed on the metal plate through the hole.

The microwave oscillator of the present invention is characterised in that the conductive layer is a thin copper foil, the metal plate is attached to the substrate by a first cream solder, the electronic component is attached to the substrate by a second cream solder, the resonator is attached to the metal plate by the second solder and the melting point of the first solder is higher than the melting point of the second solder.

Since the dielectric resonator is fixed on the metal plate by soldering, fixing is stronger and stabler as compared with conventional fixing using an adhesive. As a result, the microwave oscillator of the present invention has a high reliability against temperature changes, mechanical impact or humidity.

The present invention also provides a method of manufacturing a microwave oscillator characterised by the steps of:
1) fabricating a lamination composed of a substrate having a hole, and a metal plate soldered by a first cream solder to a bottom surface of the substrate thereby closing the bottom of the hole, said substrate having a circuit pattern on a top surface and a thin copper foil covering the bottom surface,
2) applying a second cream solder to an electronic component and positioning said component on a top surface of the substrate,
3) mounting a dielectric resonator, coated with the second cream solder, onto the metal plate through the hole in the substrate, the melting point of the first solder being higher than the melting point of the second solder,
4) heating the lamination including the mounted electronic component and the dielectric resonator at a temperature higher than the melting point of the second solder and lower than the melting point of the first solder thereby soldering the electronic component to the top surface of the substrate and at the same time soldering the dielectric resonator to the metal plate by the second solder, without influencing the soldering of the lamination by the first solder.

### BRIEF DESCRIPTION OF THE DRAWINGS

Figure 1 is a sectional view of a microwave oscillator of the present invention.

Figure 2 is an exploded perspective view of the microwave oscillator of the present invention.

Figure 3 is a sectional view of a conventional microwave oscillator.

### EMBODIMENT

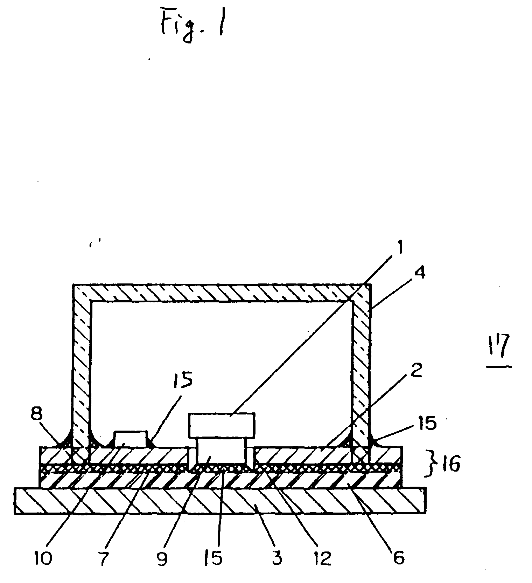

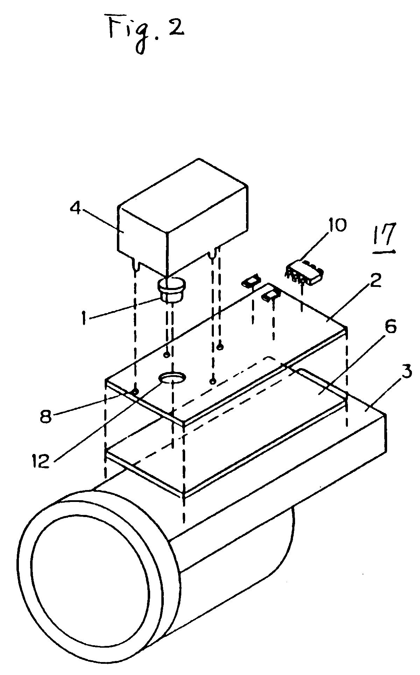

Figure 1 is a microwave oscillator 17 of the present invention. Figure 2 is a perspective exploded view of the microwave oscillator of the present invention. Referring to Figures 1 and 2, the manufacture of the microwave oscillator of the invention is explained. The manufacturing comprises the following steps.

(Step 1) A substrate 2 has a circuit pattern (not shown) on the top surface, a thin copper foil (not shown) covering the bottom surface, and a perforated hole 12. A metal plate 6 made of copper plate, brass plate, aluminum plate, galvanized steel plate, zinc solder-plated steel plate, or the like, has outer dimensions the same as or slightly larger than that of the substrate 2. A lamination 16 is prepared by stacking the substrate 2 and the metal plate 6 and soldering them using high temperature melting cream solder 7. The metal plate 6 closes the bottom of the perforated hole 12. Instead of cream solder 7, a sheet solder formed in the same shape as the dielectric substrate 2 can be used. The lamination 16 can be formed also by adhering the substrate 2 and the metal plate 6 with conductive adhesive instead of soldering.

(Step 2) Cream solder 15 is applied in specified positions on the top surface of the substrate 2, and an electronic component such as chip resistor, transistor, and IC (integraded circuit) is mounted thereon. The melting point of the cream solder 15 is selected lower than that of the cream solder 7. A dielectric resonator 1 having cream solder 15 applied to its base 9 is mounted on the metal plate 6 through the perforated hole 12 of the substrate 2. The perforated hole 12 of the substrate 2 sets the position of the dielectric resonator 1 by accommodating the base 9. Leads of the dielectric resonator 1 (not shown) are connected to the circuit pattern on the substrate through the cream solder 15 applied on the substrate. A shield case 4 is mounted on the substrate 2 by inserting a protrusion into the perforated hole 8 as shown in Figure 2. As shown in Figure 1, the cream solder 15 is applied in the inside and vicinity of the perforated hole 8.

(Step 3) The lamination 16 shown in Figure 1 on which the electronic component and shield case are mounted is heated for a short time, so that the cream solder 15 is melted. As a result, the leads of the dielectric resonator 1 and electronic component 10 are connected to the circuit pattern on the substrate 2. At the same time, the base 9 of the dielectric resonator 1 is soldered onto the metal plate 6, and the shield case 4 is soldered to the substrate 2 and metal plate 6. By this, the shield case 4 is electrically coupled with the metal plate 6 with the result that the dielectric resonator I and the electronic circuits on the substrate are shielded by the shield case 4 and the metal plate 6. During this short-time heating period, the cream solder 7 fixing the substrate 2 and the metal plate 6 is not melted because the temperature does not reach its high melting temperature.

(Step 4) As shown in Figure 2, an oscillator 17 is fixed on a mounting plate 3 on a wave guide by using, for example, screws not shown.

The microwave oscillator of the present invention is manufactured by a method comprising the above steps. At step 3, soldering of electronic component 10, soldering of dielectric resonator 1, and soldering of shield case 4 are performed at the same time. Accordingly, the manufacturing time is saved compared with the conventional process of doing these steps separately.

It is, however, sometimes required that the substrate 2 be exposed after the electronic components are soldered on the substrate for the purpose of inspection and adjustment of the electronic circuit. In such a case, the shield case 4 is assembled independently in the final step.

Since the dielectric resonator 1 is fixed on the metal plate 6 by soldering, fixing is stronger and stabler as compared with conventional fixing by adhesive, thereby enhancing the reliability against temperature changes, mechanical impact, or humidity.

## Claims

1. A microwave oscillator comprising:
a substrate (2) having a hole (12) formed therein, said substrate having a circuit pattern on a top surface and a conductive layer covering a bottom surface,
a metal plate (6) attached to the bottom surface of the substrate (7) thereby closing the bottom of the hole (12),
an electronic component (10) positioned on the top surface of the substrate (2), and
a dielectric resonator (1) positioned on the metal plate (6) through the hole (12) of the substrate (2),
characterised in that the conductive layer is a thin copper foil, the metal plate (6) is attached to the substrate (2) by a first cream solder (7), the electronic component (10) is attached to the substrate, by a second cream solder (15), the resonator is attached to the metal plate by the second solder (15) and the melting point of the first solder (7) is higher than the melting point of the second solder (15).

2. A microwave oscillator as claimed in claim 1,
wherein the outer dimensions of the metal plate (6) are equal to or slightly larger than the outer dimensions of the substrate (2).

3. A microwave oscillator as claimed in claim 1 or 2, further comprising:
a shield case (4) for covering the dielectric resonator (1) and the substrate (2), said shield case (4) being soldered to the metal plate (6) by the second solder (15).

4. A method of manufacturing a microwave oscillator (17) characterised by the steps of:
1) fabricating a lamination composed of a substrate (2) having a hole (12), and a metal plate (6) soldered by a first cream solder (7) to a bottom surface of the substrate (2) thereby closing the bottom of the hole (12), said substrate having a circuit pattern on a top surface and a thin copper foil covering the bottom surface,
2) applying a second cream solder to an electronic component (10) and positioning said component on a top surface of the substrate,
3) mounting a dielectric resonator (1), coated with the second cream solder (15), onto the metal plate (6) through the hole (12) in the substrate (2), the melting point of the first solder (7) being higher than the melting point of the second solder (15),
4) heating the lamination including the mounted electronic component and the dielectric resonator at a temperature higher than the melting point of the second solder and lower than the melting point of the first solder thereby soldering the electronic component to the top surface of the substrate and at the same time soldering the dielectric resonator to the metal plate by the second solder, without influencing the soldering of the lamination by the first solder.

## Patentansprüche

1. Mikrowellenoszillator, der umfaßt:
ein Substrat (2), das eine in ihm gebildete Öffnung (12) aufweist, wobei das Substrat ein Schaltungsmuster auf seiner oberen Fläche und eine die untere Fläche überdeckende, leitende Schicht aufweist,
eine Metallplatte (6), die an der unteren Fläche des Substrats (7) angebracht ist, wodurch sie die Unterseite der Öffnung (12) schließt,
eine elektronische Komponente (10), die auf der oberen Fläche des Substrats (2) angeordnet ist, und
einen dielektrischen Resonator (1), der auf der Metallplatte (6) durch die Öffnung (12) des Substrats (2) hindurch angeordnet ist,
**dadurch gekennzeichnet**, daß die leitende Schicht eine dünne Kupferfolie ist, die Metallplatte (6) an dem Substrat (2) durch ein erstes Weichlot (7) angebracht ist, das elektronische Bauteile (10) an dem Substrat durch ein zweites Weichlot (15) angebracht ist, der Resonator an der Metallplatte durch das zweite Lot (15) angebracht ist und der Schmelzpunkt des ersten Lots (7) höher als der Schmelzpunkt des zweiten Lots (15) ist.

2. Ein Mikrowellenoszillator, wie in Anspruch 1 beansprucht, wobei die Außenabmessungen der Metallplatte (6) gleich oder etwas größer als die Außenabmessungen des Substrats (2) sind.

3. Ein Mikrowellenoszillator, wie in Anspruch 1 oder 2 beansprucht, der des weiteren umfaßt:
ein Abschirmgehäuse (4), um den dielektrischen Resonator (1) und das Substrat (2) zu überdecken, wobei das Abschirmgehäuse (4) an der Metallplatte (6) durch das zweite Lot (15) angelötet ist.

4. Ein Verfahren zur Herstellung eines Mikrowellenoszillators (17), das durch die Schritte gekennzeichnet ist:
1) Herstellen eines Schichtaufbaus, der aus einem Substrat (2) mit einer Öffnung (12) und einer Metallplatte (6) gebildet ist, die mit einem ersten Weichlot (7) an der Unterfläche des Substrats (2) angelötet ist, wodurch die Unterseite der Öffnung (12) geschlossen wird, wobei das Substrat ein Schaltungsmuster auf seiner oberen Fläche aufweist und eine dünne Kupferfolie die Unterfläche überdeckt,
2) Anwenden eines zweiten Weichlots auf ein elektronisches Bauteil (10) und Anordnen des Bauteils auf der oberen Fläche des Substrats,
3) Befestigen eines dielektrischen Resonators (1), der mit dem zweiten Weichlot (15) beschichtet ist, auf der Metallplatte (6) durch die Öffnung (12) in dem Substrat (2) hindurch, wobei der Schmelzpunkt des ersten Lots (7) höher als der Schmelzpunkt des zweiten Lots (15) ist,
4) Erwärmen des Schichtaufbaus einschließlich des angebrachten elektronischen Bauteils und des dielektrischen Resonators auf eine Temperatur, die höher als der Schmelzpunkt des zweiten Lots und niedriger als der Schmelzpunkt des ersten Lots ist, wodurch der elektronische Bauteil an der oberen Fläche des Substrats angelötet und gleichzeitig der dielektrische Resonator an der Metallplatte durch das zweite Lot angelötet wird, ohne die Lötverbindung des Schichtaufbaus mit dem ersten Lot zu beeinflussen.

## Revendications

1. Oscillateur hyperfréquence comportant :
un substrat (2) présentant un trou (12) pratiqué à l'intérieur, ledit substrat présentant une configuration de circuit sur une surface supérieure et une couche conductrice recouvrant une surface inférieure,
une plaque métallique (6) fixée à la surface inférieure du substrat (7) fermant ainsi le fond du trou (12),
un composant électronique (10) disposé sur la surface supérieure du substrat (2), et
un résonateur diélectrique (1) disposé sur la plaque métallique (6) à travers le trou (12) du substrat (2),
caractérisé en ce que la couche conductrice est une mince feuille de cuivre, la plaque métallique (6) est fixée au substrat (2) par une première pâte de soudure (7), le composant électronique (10) est fixé au substrat par une seconde pâte de soudure (15), le résonateur est fixé à la plaque métallique par la seconde soudure (15) et le point de fusion de la première soudure (7) est plus élevé que le point de fusion de la seconde soudure (15).

2. Oscillateur hyperfréquence selon la revendication 1, dans lequel les dimensions extérieures de la plaque métallique (6) sont égales ou légèrement supérieures aux dimensions extérieures du substrat (2).

3. Oscillateur hyperfréquence selon la revendication 1 ou 2, comportant en outre :
un capot de blindage (4) afin de recouvrir le résonateur diélectrique (1) et le substrat (2), ledit capot de blindage (4) étant soudé à la plaque métallique (6) par la seconde soudure (15).

4. Procédé de fabrication d'un oscillateur hyperfréquence (17) caractérisé par les étapes consistant à:
1) fabriquer un stratifié constitué d'un substrat (2) possédant un trou (12) et une plaque métallique (6) soudée par une première pâte de soudure (7) à une surface inférieure du substrat (2) fermant ainsi le fond du trou (12), ledit substrat possédant une configuration de circuit sur une surface supérieure et une mince feuille de cuivre recouvrant la surface inférieure,
2) appliquer une seconde pâte de soudure à un composant électronique (10) et disposer ledit composant sur une surface supérieure du substrat,
3) monter un résonateur diélectrique (1), revêtu de la seconde pâte de soudure (15), sur la plaque métallique (6) à travers le trou (12) dans le substrat (2), le point de fusion de la première soudure (7) étant supérieur au point de fusion de la seconde soudure (15),
4) chauffer le stratifié comprenant le composant électronique monté et le résonateur diélectrique à une température supérieure au point de fusion de la seconde soudure et inférieure au point de fusion de la première soudure en soudant ainsi le composant électronique à la surface supérieure du substrat et en soudant simultanément le résonateur diélectrique à la plaque métallique par la seconde soudure, sans influencer le soudage du stratifié par la première soudure.
